# EUROPÄISCHE PATENTSCHRIFT

(11) **EP 1 384 233 B1**
(45) Veröffentlichungstag und Bekanntmachung des Hinweises auf die Patenterteilung: **20.10.2004**
(21) Anmeldenummer: 01990314.5
(22) Anmeldetag: 18.12.2001
(51) Int. Cl.: G11C 29/00, G11C 17/16, G11C 17/18

(54) **SCHALTUNGSANORDNUNG ZUR ANSTEUERUNG EINER PROGRAMMIERBAREN VERBINDUNG**
CIRCUIT ARRANGEMENT FOR CONTROLLING A PROGRAMMABLE CONNECTION
CIRCUITERIE POUR PILOTER UNE LIAISON PROGRAMMABLE

(30) Priorität: 20.12.2000 DE 10063684
(43) Veröffentlichungstag der Anmeldung: 28.01.2004
(73) Patentinhaber: Infineon Technologies AG, 81669 München (DE)
(72) Erfinder: KAISER, Robert, 86916 Kaufering (DE); SCHAMBERGER, Florian, 83435 Bad Reichenhall (DE)
(74) Vertreter: Epping Hermann & Fischer
(86) Internationale Anmeldenummer: PCT/DE2001/004786
(87) Internationale Veröffentlichungsnummer: WO 2002/050838

(56) Entgegenhaltungen:
- FR-A- 2 611 400
- US-A- 5 424 672
- US-A- 5 442 589
- US-A- 5 631 862

## Beschreibung

Die vorliegende Erfindung betrifft eine Schaltungsanordnung zur Ansteuerung einer programmierbaren Verbindung sowie deren Verwendung in einem Speicherchip.

In Speicherchips, beispielsweise SD-RAMs (Synchronous Dynamic Random Access Memory), welche beispielsweise einen Speicherplatz von 256 Megabyte aufweisen, sind üblicherweise zur Bereitstellung einer Redundanz Ersatz-Speicherzellen vorgesehen, welche fertigungsbedingte Ausfälle einzelner Speicherzellen ausgleichen können. Hierzu sind programmierbare Verbindungen, die auch als Fuses bezeichnet werden, vorgesehen, mit denen ein Ersetzen von defekten Speicherzellen mit Ersatzzellen ermöglicht ist. Beispielsweise bei 256 MegaByte-RAMs können einige tausend Fuses vorgesehen sein.

Die Fuses können in bekannter Weise entweder mit einem Energieimpuls in Form eines Lasers oder durch einen elektrischen Impuls, beispielsweise einen Spannungs- oder einen Stromimpuls, dauerhaft umgeschaltet werden. Dabei unterscheidet man die sogenannten Fuses, welche mit dem beschriebenen Energieimpuls von einem leitenden (niederohmigen) in einen nichtleitenden (hochohmigen) Zustand versetzt werden können, und Antifuses, welche durch Beaufschlagen mit einem Energieimpuls von einem nichtleitenden in einen leitenden Zustand gebracht werden können.

Das sogenannte Aktivieren, Brennen oder Schießen von Fuses, welches ein einmaliger Vorgang ist, mit dem die Fuse dauerhaft von einem niederohmigen in einen hochohmigen oder von einem hochohmigen in einen niederohmigen Zustand gebracht wird, erfolgt bisher üblicherweise mittels Laser vor einem Vergießen des Speicherchips. Damit ist jedoch der Nachteil verbunden, daß keine Reparatur defekter Speicherzellen nach Vergießen des Chips mehr möglich ist.

Weiterhin ist es üblich, die Speicherzellen einer ganzen Wortleitung in einem Speicherchip zu ersetzen, wünschenswert ist jedoch das Ersetzen einzelner Adressen von Speicherzellen, das sogenannte Single Address Repair.

Bei einem Brennen von Fuses mittels Strom- oder Spannungsimpulsen, welches prinzipiell auch nach Vergießen eines Chips möglich ist, tritt jedoch das Problem auf, daß das gleichzeitige Brennen oder Schießen mehrerer Fuses eine unzulässig hohe Stromaufnahme der Schaltung mit sich bringt.

Aufgabe der vorliegenden Erfindung ist es, eine Schaltungsanordnung zur Ansteuerung einer programmierbaren Verbindung anzugeben, welche eine Reparatur von defekten Speicherzellen in einem elektronischen Massenspeicher auch nach einem Vergießen ermöglicht und bei der keine unzulässig hohe Stromaufnahme auftritt.

Eine Schaltungsanordnung gemäß des Oberbegriffs des Anspruchs 1 ist aus US-A-5 631 862 bekannt.

Erfindungsgemäß wird die Aufgabe gelöst mit einer Schaltungsanordnung zur Ansteuerung einer programmierbaren Verbindung, aufweisend
- die mit einem Energieimpuls bezüglich ihres Leitzustands programmierbare Verbindung,
- eine Ansteuerschaltung zur Bereitstellung des Energieimpulses an ihrem Ausgang, der mit der programmierbaren Verbindung gekoppelt ist, in Abhängigkeit von eingangsseitig anliegenden Signalen und
- ein Schieberegister mit zumindest einer Registerzelle zum Speichern eines Aktiviersignals, welche mit einem Aktiviereingang der Ansteuerschaltung zu deren Aktivierung in Abhängigkeit vom Speicherinhalt der Registerzelle gekoppelt ist.

Die programmierbaren Verbindung kann als Fuse oder als Antifuse ausgebildet sein.

Die Registerzelle des Schieberegisters kann an ihrem Ausgang an einen Eingang einer weiteren Schieberegisterzelle einer weiteren Schaltungsanordnung, wie oben beschrieben, angeschlossen sein. Dabei kann eine Registerkette gebildet sein, wobei jeder Registerzelle eine programmierbare Verbindung zugeordnet sein kann. An den Eingang einer ersten Registerzelle in der Schieberegisterkette kann ein Bitmuster-Generator angeschlossen sein. Dieser ermöglicht es, je nach maximal zulässigem Strom zum Brennen der programmierbaren Verbindungen, beispielsweise eine oder mehrere Einsen taktgesteuert nacheinander durch die Registerkette schieben. Ist während einer Taktphase eine 1 in einer Registerzelle gespeichert, so ist die zugehörige Ansteuerschaltung aktiviert, so daß in diesem Fall beispielsweise in Abhängigkeit eines Datensignals die programmierbare Verbindung gebrannt werden kann.

Eine Adresse zum Adressieren einer Speicherzelle, die fehlerhalft sein kann, in einem Speicherchip, kann mehrere Bit, beispielsweise 25 Bit Speicherbedarf haben. Die beschriebene Schaltungsanordnung ist vorzugsweise zum Speichern eines einzelnen Bits ausgelegt. Dabei kann dieses Bit vorteilhafterweise sowohl im flüchtigen Speicher schnell abgelegt werden als auch dauerhaft mittels der programmierbaren Verbindung gespeichert werden. Um eine vollständige Adresse, wie oben beschrieben mit 25 Bit, ablegen zu können, können 25 der beschriebenen Schaltungsanordnungen vorgesehen sein. Die Schieberegister der einzelnen Schaltungsanordnungen können dabei wie bereits beschrieben zu einer Schieberegisterkette miteinander verbunden sein. Somit ist ein einfaches Umprogrammieren defekter Speicherzellen und deren Ersetzen durch redundante, intakte Speicherzellen ermöglicht.

Mit der beschriebenen Schaltungsanordnung ist ein Brennen von programmierbaren Verbindungen, beispielsweise in SD-RAMS, auch nach einem Vergießen eines Halbleiterplättchens, welches eine Vielzahl von Speicherzellen aufweist, möglich. Zudem kann in einfacher Weise ein Überschreiten eines maximal zulässigen Stromes beim Brennen der programmierbaren Verbindungen verhindert werden. Mittels des Schieberegisters können auch gezielt einzelne programmierbare Verbindungen oder Fuses geschossen oder gebrannt werden, beispielsweise nach einem Fehlschlagen eines ersten Versuches, indem gezielt eine logische 1 in die gewünschte, der betreffenden programmierbaren Verbindung zugeordneten Registerzelle geschoben wird.

Der Brennvorgang selbst kann beispielsweise durch Anlegen einer Brennspannung an alle Ansteuerschaltungen, welche je einer Registerzelle und je einer programmierbaren Verbindung zugeordnet sein können, erfolgen.

In einer bevorzugten Ausführungsform der vorliegenden Erfindung ist ein flüchtiger Speicher mit einer Speicherzelle vorgesehen, die mit einem Dateneingang der Ansteuerschaltung gekoppelt ist zum dauerhaften Speichern des Speicherinhalts der Speicherzelle des flüchtigen Speichers mittels der programmierbaren Verbindung.

Beispielsweise zum Speichern eines Bits einer Adressinformation einer defekten Speicherzelle im SD-RAM kann die Speicherzelle im flüchtigen Speicher vorgesehen sein. Die programmierbare Verbindung kann bei Anlegen beispielsweise einer Brennspannung nur dann gebrannt oder geschossen, wenn sowohl eine 1 in der Speicherzelle des flüchtigen Speichers gespeichert ist, als auch eine 1 in der Registerzelle des Schieberegisters gespeichert ist. Hierfür kann beispielsweise die Ansteuerschaltung einen Dateneingang haben, der mit der Speicherzelle des flüchtigen Speichers verbunden ist und einen Aktiviereingang haben, der mit der Registerzelle des Schieberegisters verbunden ist. Zudem ermöglicht das Speichern fehlerhafter Speicheradressen im flüchtigen Speicher eine Korrektur oder Reparatur defekter Speicherzellen im SD-RAM in Echtzeit, denn beispielsweise bei einer Taktrate von 100 MHz, das heißt bei einer Periodendauer von 10 Nanosekunden, ist es nicht möglich, eine programmierbare Verbindung zu brennen.

Weiterhin kann der flüchtige Speicher auch mit der programmierbaren Verbindung zum Auslesen der programmierbaren Verbindung verbunden sein, so daß beispielsweise die Information, ob die programmierbare Verbindung gebrannt oder noch nicht gebrannt ist, als logische 0 oder logische 1 in den flüchtigen Speicher, genauer dessen Speicherzelle, übertragbar ist.

In weiteren, bevorzugten Ausführungsform der vorliegenden Erfindung ist die programmierbare Verbindung als Antifuse ausgebildet, die bei Beaufschlagen mit dem Energieimpuls von einem nichtleitenden in einen leitenden Zustand dauerhaft wechselt. Beispielsweise können zwei Elektroden vorgesehen sein, welche über ein Dielektrikum miteinander gekoppelt sind, welches zunächst isolierend wirkt, so daß die Elektroden hochohmig miteinander verbunden sind. Wird jedoch ein Energieimpuls, beispielsweise eine Spannung von beispielsweise 6 Volt über den Elektroden der Antifuse angelegt, so bricht das Dielektrikum durch und es ergibt sich eine dauerhaft niederohmige Verbindung zwischen den beiden Elektroden, das heißt zwischen zwei Anschlüssen der Antifuse. Alternativ kann die programmierbare Verbindung auch als Fuse ausgebildet sein.

In einer weiteren, bevorzugten Ausführungsform der vorliegenden Erfindung umfaßt die Ansteuerschaltung einen Brenntransistor, dessen Steuereingang mit Aktivier- und Dateneingang verbunden ist und der in Abhängigkeit von an Steuer- und Dateneingang anliegenden Signalen einen Anschluß seiner gesteuerten Strecke, an dem eine Brennspannung zuführbar ist, niederohmig mit einem weiteren Anschluß einer gesteuerten Strekke verbindet, der mit der programmierbaren Verbindung gekoppelt ist, verbindet. Mit dem Brenntransistor ist das Ansteuern und Brennen der programmierbaren Verbindung mittels eines Spannungsimpulses in einfacher Weise ermöglicht.

In einer weiteren, vorteilhaften Ausführungsform der vorliegenden Erfindung ist eingangsseitig am Brenntransistor eine Schaltung zur Pegelerhöhung vorgesehen. Die Schaltung zur Pegelerhöhung kann beispielsweise an einen Steuereingang sowie an einen ersten Lastanschluß des Brenntransistors angeschlossen sein. An einem Lastanschluß des Brenntransistors kann gegen einen Versorgungsspannungsanschluß die programmierbare Verbindung angeschlossen sein. Die Schaltung zur Pegelerhöhung setzt logische Pegel von der Schaltung zur Pegelerhöhung zuführbaren Eingangssignalen in einen höheren logischen Pegel am Ausgang der Schaltung zur Pegelerhöhung um. Hierdurch kann sichergestellt sein, daß am Steuereingang des Brenntransistors ein ausreichend hoher Pegel bereitsteht, um ein sicheres Abschalten desselben zu gewährleisten, auch dann, wenn der Brenntransistor eine verhältnismäßig hohe Brennspannung schaltet. Der Eingangspegel an der Schaltung zur Pegelerhöhung liegt beispielsweise in einem Bereich von 0 Volt bis 2,5 Volt. Ausgangsseitig an der Schaltung zur Pegelerhöhung ist dann beispielsweise ein verschobener logischer Pegel in einem Bereich von 0 Volt bis 4 Volt bereitgestellt. Hierdurch ist gewährleistet, daß ein an den Ausgang der Schaltung zur Pegelerhöhung mit seinem Steuereingang angeschlossener Brenntransistor auch eine hohe Brennspannung von beispielsweise 4 Volt sicher abschalten kann.

In einer weiteren, bevorzugten Ausführungsform der vorliegenden Erfindung weist die Ansteuerschaltung eine UND-Logikschaltung auf, welche Aktivier- und Dateneingang verknüpft und ausgangsseitig mit der programmierbaren Verbindung gekoppelt ist.

In einer weiteren, bevorzugten Ausführungsform der vorliegenden Erfindung umfaßt das Schieberegister einen ersten mit einem ersten Taktsignal steuerbaren Schalter, der einen Eingang des Schieberegisters mit einem Eingang der Registerzelle koppelt, und einen zweiten, mit einem zweiten Taktsignal steuerbaren Schalter, der einen Ausgang der Registerzelle mit einem Ausgang des Schieberegisters koppelt.

Mit erstem und zweitem Taktsignal können beispielsweise logische Einsen nacheinander durch mehrere Registerzellen seriell zusammengeschalteter Schieberegister geschoben werden, wobei jedes Schieberegister je einer Ansteuerschaltung je einer programmierbaren Verbindung zugeordnet sein kann.

In einer weiteren, bevorzugten Ausführungsform der vorliegenden Erfindung ist die Schaltungsanordnung in CMOS-Schaltungstechnik aufgebaut.

In einer weiteren, bevorzugten Ausführungsform der vorliegenden Erfindung ist diese in einem SD-RAM-Chip vorgesehen.

Beispielsweise in einem 256 Megabyte-SD-RAM können 10.000 beschriebene Schaltungsanordnungen vorgesehen sein. Die jeweils vorgesehenen Registerzellen können beispielsweise alle hintereinander geschaltet sein, oder es können mehrere, parallel geschaltete Stränge vorgesehen sein, welche jeweils eine Vielzahl seriell hintereinander geschalteter Registerzellen aufweisen.

Weitere Einzelheiten der Erfindung sind.in den Unteransprüchen angegeben.

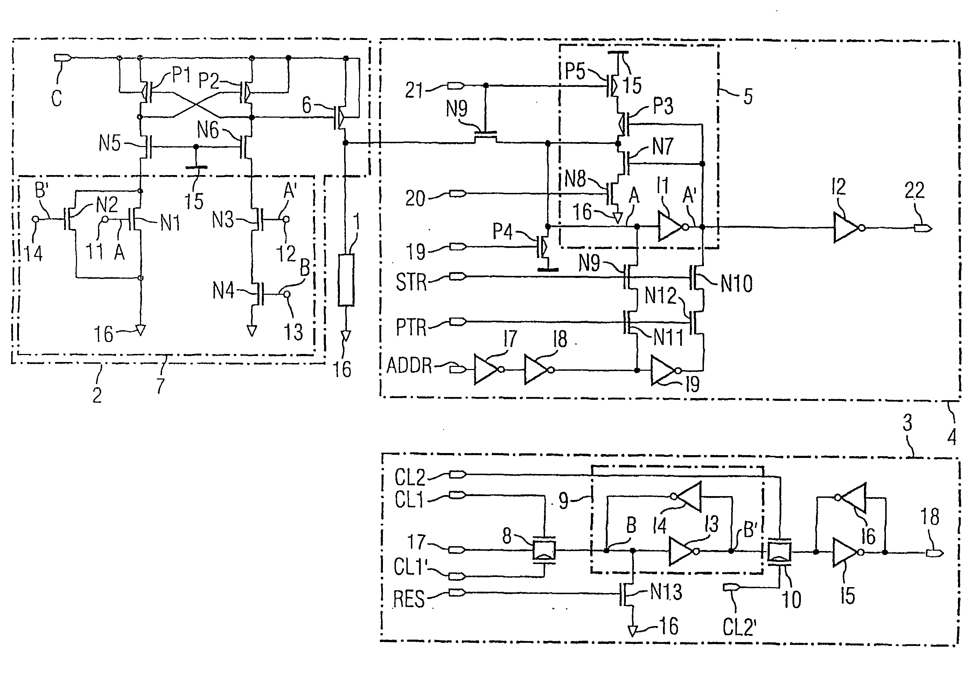

Die Erfindung wird nachfolgend an einem Ausführungsbeispiel anhand der Zeichnung näher erläutert.

### Es zeigt:

Die Figur ein Ausführungsbeispiel der Erfindung anhand eines vereinfachtes Schaltbilds.

Die Figur zeigt eine als Antifuse ausgebildete programmierbare Verbindung 1, welche mit einem Anschluß an einen Versorgungsspannungsanschluß 16 und mit einem weiteren Anschluß an eine Ansteuerschaltung 2 angeschlossen ist. Die Ansteuerschaltung 2 ist zur Zuführung eines Aktiviersignals B, B' mit einem Schieberegister 3 verbunden. Weiterhin ist ein flüchtiger Speicher 4 vorgesehen, der zum einen zum Auslesen des Zustandes der Antifuse 1 mit dem weiteren Anschluß derselben verbunden ist und zum anderen zur Zuführung eines Datensignals A, A' an einen Dateneingang 11, 12 mit der Ansteuerschaltung 2 verbunden ist.

Die Ansteuerschaltung 2 umfaßt eine UND-Logikschaltung 7, welche Datensignal A, A' und Aktiviersignal B, B' in einer logischen UND-Verknüpfung miteinander verknüpft. Hierfür sind zwei parallelgeschaltete NMOS-Transistoren N1, N2 vorgesehen, von denen ein erster NMOS-Transistor N1 einen Steuereingang aufweist, der an einen Dateneingang 11 angeschlossen ist und ein zweiter NMOS-Transistor N2 einen Steuereingang aufweist, der zur Zuführung des Aktiviersignals B einen Aktiviereingang 14 aufweist. Weiterhin sind zur Zuführung jeweils komplementärer oder inverser Daten- und Aktiviersignale A' ,B' weitere NMOS-Transistoren N3, N4 in der UND-Logikschaltung 7 vorgesehen, welche mit ihren gesteuerten Strecken in Serie geschaltet sind, und von denen ein erster NMOS-Transistor N3 einen Steuereingang aufweist, der an einen Dateneingang 12 angeschlossen ist zur Zuführung des komplementären Datensignals A' und ein zweiter NMOS-Transistor N4 einen Steuereingang aufweist, der mit einem Aktiviereingang 13 zur Zuführung eines komplementären Aktiviersignals B' angeschlossen ist.

Die NMOS-Transistoren N1, N3 mit dem Dateneingang 11, 12 sind zugleich Teil einer Schaltung zur Pegelerhöhung, welche steuerseitig an den Brenntransistor 6 angeschlossen ist. Die Schaltung zur Pegelerhöhung, welche Teil der Ansteuerschaltung 2 ist, weist zwei kreuzgekoppelte PMOS-Transistoren P1, P2 auf, welche über weitere NMOS-Transistoren N5, N6 mit der Und-Logikschaltung 7 verbunden sind. Ausgangsseitig an der Schaltung zur Pegelerhöhung P1, P2, N5, N6 ist ein als PMOS-Transistor ausgeführter Brenntransistor 6 angeschlossen, der mit einem Lastanschluß mit der Antifuse 1 sowie mit dem flüchtigen Speicher 4 zum Auslesen des Zustands der Antifuse 1 verbunden ist.

Der flüchtige Speicher 4 umfaßt eine Speicherzelle 5, welche aus zwei miteinander verbundenen Invertern I1; P3, N7 gebildet ist. Dabei ist ein erster Inverter I1 vorgesehen, an dessen Eingang das Datensignal A ableitbar ist und an dessen Ausgang ein komplementäres oder inverses Datensignal A' ableitbar ist. Ein PMOS-Transistor P3 sowie ein NMOS-Transistor N7, deren Steuereingänge miteinander und mit dem Ausgang des ersten Inverters I1 verbunden sind, bilden den zweiten Inverter, dessen Ausgang mit dem Eingang des ersten Inverters I1 verbunden ist. Die Inverter 11 sowie P3, N7 bilden somit als Speicherzelle ein rückgekoppeltes Latch mit Selbsthaltung.

An der Speicherzelle 5 sind zum Zweck des Auslesens des aktuellen Zustands der Antifuse 1 Hilfseingänge 19, 20, 21 vorgesehen. Zunächst wird mit Hilfseingang 19 und einem daran mit seinem Steuereingang angeschlossenen PMOS-Transistor P4 zum Auslesen des Zustands der Antifuse 1 eine logische 1 in die Speicherzelle 5 geschrieben und dort selbst gehalten. Anschließend wird mit Hilfseingängen 20, 21, die zueinander komplementäre CMOS-Transistoren P5, N8 der Speicherzelle 5 ansteuern, ein Tristate-Zustand in der Speicherzelle 5 gebildet, welcher die Speicherzelle 5, insbesondere den Inverter P3, N7 hochohmig mit den Versorgungsspannungsanschlüssen 15, 16 verbindet. Zugleich wird ein ebenfalls an Hilfseingang 21 zu seiner Steuerung angeschlossener NMOS-Transistor N9, welcher zwischen einem Anschluß der Antifuse 1 und einem Eingang der Speicherzelle 5 angeschlossen ist, geöffnet. Hierdurch ist bewirkt, daß der Schaltungsknoten am Eingang des ersten Inverters I1 in der Speicherzelle 5 hochohmig bleibt, wenn die Antifuse 1 ebenfalls hochohmig ist, und in einen niederohmigen Zustand übergeht, wenn die als Antifuse ausgebildete Antifuse 1 niederohmig, das heißt bereits geschossen ist. Im letzteren Fall entlädt sich der Eingangsknoten des ersten Inverters I1, welcher das Datensignal A bereitstellt, über Transistor N9 und die in diesem Fall leitende Antifuse 1. Sobald der Zustand der Antifuse 1, das heißt, ob die Antifuse niederohmig leitend oder hochohmig ist, als logische 0 oder 1 in die Speicherzelle 5 ausgelesen ist, werden die hierfür an den Hilfseingängen 20, 21 angelegten Signale entfernt und die Speicherzelle 5 geht wieder in Selbsthaltung über. Mit einem Inverter 12, welcher an den Ausgang des ersten Inverters I1 mit seinem Eingang angeschlossen ist, kann das Datensignal A beziehungsweise das inverse Datensignal A' an einem Ausgang 22 aus Speicherzelle 5 ausgelesen werden. Weiterhin ist die Speicherzelle 5 mit einem Adresseingang ADDR gekoppelt, der eingangsseitig an drei hintereinandergeschalteten Invertern I7, I8, I9 angeschlossen ist. Zur Kopplung des Adresseingangs ADDR mit der Speicherzelle 5 sind weiterhin zwei Paare von NMOS-Transistoren N9, N10; N11, N12 vorgesehen, deren Steuereingänge mit einem Strobe-Eingang STR und mit einem Pointer-Eingang PTR verbunden. Mit Strobe- und Pointer-Signalen auf den Auswahlleitungen Strobe STR, Pointer PTR kann ein Bit einer Adresse einer Speicherzelle beispielsweise eines SD-RAMs in die Speicherzelle 5 geschrieben werden, wobei die Speicherzelle im SD-RAM, auf die die Adresse zeigt, von der ein Bit am Eingang ADDR zuführbar ist, fehlerhaft sein kann. Ist die Adresse fehlerhaft, so kann mit Auswahlleitungen Strobe, Pointer STR, PTR, welche hierzu aktivierbar sind, das am Adress-Eingang ADDR anliegende Bit der betreffenden fehlerhaften Speicherzellenadresse in die Speicherzelle 5 geschrieben werden.

Mit Speicherzelle 5 kann jedoch, da diese lediglich einen flüchtigen Speicher bildet, keine dauerhafte Speicherung des Bits der Adresse der fehlerhaften Speicherzelle ermöglicht sein. Deshalb ist mit der beschriebenen Ansteuerschaltung 2 das Auslesen der Speicherzelle 5, das heißt des Datensignals A, A' über die bereits beschrieben UND-Steuerlogik 7 sowie das dauerhafte Speichern des ausgelesenen Datums mit dem Brenntransistor 6 in der Antifuse 1 möglich. Die UND-Logikschaltung 7 verknüpft dabei das Datensignal A, A' mit einem Aktiviersignal B, B' in einer UND-Verknüpfung. Folglich wird die Antifuse 1 nur dann gebrannt oder geschossen, wenn sowohl in Speicherzelle 5 eine logische 1 gespeichert ist, als auch zusätzlich am Aktiviereingang 13, 14 eine logische 1 durch das Aktiviersignal B, B' bereitgestellt ist. Schließlich ist für einen Brennvorgang der Antifuse 1 gemäß Ausführungsbeispiel noch erforderlich, daß eine Brennspannung C an den die bereits beschriebene Pegelerhöhungsschaltung bildenden PMOS-Transistoren P1, P2 sowie am Brenntransistor 6 anliegt.

Das Aktviersignal B, B' kann nun gemäß der vorliegenden Erfindung mit dem Schieberegister 3 in der Registerzelle 9 bereit gestellt sein, welche ebenfalls zwei gegengekoppelte Inverter I3, I4 aufweist, welche eine Selbsthalteschaltung bilden. Am Eingang der Registerzelle 9, sowie am Ausgang der Registerzelle 9 ist jeweils ein als PMOS-Transfergate ausgeführter Schalter 8, 10 angeschlossen. Während der eingangsseitig angeschlossene Schalter 8 mit einem ersten Taktsignal CL1, CL1' ansteuerbar ist, kann der ausgangsseitig angeordnete Schalter 10 mit einem zweiten Taktsignal CL2, CL2', welches dem Schalter 10 zuführbar ist, angesteuert werden. Über einen NMOS-Transistor N13, welcher den Eingang der Speicherzelle 9 mit einem Versorgungsspannungsanschluß 16 verbindet, und der steuerseitig an einen Rücksetz-Eingang RES angeschlossen ist, kann der Speicherinhalt der Registerzelle 9 zurückgesetzt werden. Ausgangsseitig an Registerzelle 9 und dem ausgangsseitigen Schalter 10 nachgeschaltet weist das Schieberegister 3 eine weitere Selbsthalteschaltung auf, welche mit zwei ebenfalls gegengekoppelten Invertern 15, 16 realisiert ist und den Schalter 10 mit einem Ausgang 18 des Schieberegisters 3 koppelt. Der Eingang des Schieberegisters 3, welcher an einen Eingang des eingangsseitigen Schalters 8 angeschlossen ist, ist mit 17 bezeichnet.

Wie bereits beschrieben, werden Speicherzellen in SD-RAM-Chips, welche beispielsweise 256 Megabyte Speicherplatz haben können, über Adressen selektiert. Eine solche Adresse kann beispielsweise 25 Bit aufweisen. Zur Adressierung einer einzelnen Speicherzelle eines SD-RAM-Chips sind demnach 25 der in der Figur gezeigten Schaltungen, umfassend Antifuse 1, Ansteuerschaltung 2, flüchtiger Speicher 4 und Schieberegister 3 erforderlich. Um beim Brennen der Sicherungen 1 jedoch einen unzulässig hohen Stromfluß, welcher kurzzeitig pro Antifuse circa 1 mA betragen kann, zu vermeiden, können die einzelnen Ansteuerschaltungen 2 für die Sicherungen 1 mit Schieberegister 3 nacheinander oder teilweise gleichzeitig selektiert oder angesprochen werden. Hierfür können die mehreren Schieberegister 3 in einer Serienschaltung miteinander verbunden sein, wobei jeweils ein Eingang 17 einer Schieberegisterschaltung 3 mit einen Ausgang 18 einer anderen Schieberegisterschaltung 3 verbunden sein kann. Hierdurch ist eine Schieberegisterkette gebildet. Die miteinander über Schalter 8, 10 jeweils verbunden Registerzellen 9 können auch als ein Register aufgefaßt werden. Am Eingang der ersten Registerzelle kann ein Bitmuster-Generator angeschlossen sein(nicht eingezeichnet). Darf lediglich eine Antifuse gleichzeitig gebrannt werden, so ist mit dem Bitmuster-Generator am Eingang der Schieberegisterkette eine Bitfolge bereitstellbar, welche lediglich eine logische 1 aufweist und mit Nullen aufgefüllt wird. Diese logische 1 wird nun nacheinander durch alle Registerzellen 9 des Schieberegisters geschoben, so daß jeweils mit dem jeweiligen Aktiviersignal B nur eine Ansteuerschaltung 2 zur Zeit aktiviert ist. Zur Steuerung des Ablaufes sind die Taktsignale CL1, CL1' und CL2, CL2' vorgesehen. Können mehrere Sicherungen 1 gleichzeitig gebrannt werden, so können mit Schieberegister 3 selbstverständlich auch mehrere, unmittelbar aufeinander folgende Einsen oder in einem einstellbaren Abstand durch Nullen beabstandete Einsen durch die Schieberegisterkette geschoben werden.

Die beschriebene Schaltungsanordnung ermöglicht mit dem schnellen, flüchtigen Speicher 4 eine Korrektur fehlerhafter Speicherzellen in einem Massenspeicherchip in Echtzeit. Beispielsweise vor einem Ausschalten des Massenspeicherchip können die jeweiligen Adressen der fehlerhaften Speicherzellen dauerhaft geschrieben werden, wofür die Ansteuerschaltungen 2 und die Antifuse 1 vorgesehen sind. Somit ist ein Brennen von Sicherungen 1 zur dauerhaften Speicherung fehlerhafter Adressen, genauer Adressen fehlerhafter Speicherzellen, ermöglicht. Dieses ist auch nach Vergießen und Umhäusen des Massenspeicherchips noch möglich, da die Antifuse 1 elektrisch ansteuerbar ist. Schließlich bietet die Erfindung den Vorteil, daß nicht nur ein unzulässig hoher Brennstrom durch gleichzeitiges Brennen zu vieler Sicherungen auftreten kann, sondern daß zudem durch beliebig generierbare und durch die Registerzellen 9 schiebbare Bitmuster eine beliebige Anzahl Sicherungen 1 gleichzeitig sowie in beliebiger Reihenfolge gebrannt werden können.

### Bezugszeichenliste

- A, A': Datensignal
- B, B': Aktiviersignal
- C: Brennspannung
- N1 bis N13: NMOS-Transistor
- P1 bis P5: PMOS-Transistor
- I1 bis I9: CMOS-Inverter
- STR: Strebe-Eingang
- PTR: Pointer-Eingang
- ADDR: Adress-Eingang
- RES: Rücksetz-Eingang
- CL1, CL1': Taktsignal
- CL2, CL2': Taktsignal
- 1: Programmierbare Verbindung
- 2: Ansteuerschaltung
- 3: Schieberegister
- 4: Flüchtiger Speicher
- 5: Speicherzelle
- 6: Brenntransistor
- 7: Und-Logikschaltung
- 8: Schalter
- 9: Registerzelle
- 10: Schalter
- 15: Versorgungsspannungsanschluß
- 16: Versorgungsspannungsanschluß
- 17: Eingang
- 18: Ausgang
- 19, 20, 21: Hilfseingang
- 22: Ausgang
- 11, 12: Dateneingang
- 13, 14: Aktiviereingang

## Patentansprüche

1. Schaltungsanordnung zur Ansteuerung einer programmierbaren Verbindung (1), aufweisend
- die mit einem Energieimpuls bezüglich ihres Leitzustands programmierbare Verbindung (1),
- eine Ansteuerschaltung (2) zur Bereitstellung des Energieimpulses an ihrem Ausgang, der mit der programmierbaren Verbindung (1) gekoppelt ist, in Abhängigkeit von eingangsseitig anliegenden Signalen (A, A', B, B')
- **gekennzeichnet durch** ein Schieberegister (3) mit zumindest einer Registerzelle (9) zum Speichern eines Aktiviersignals (B, B'), welche mit einem Aktiviereingang (13, 14) der Ansteuerschaltung zu deren Aktivierung in Abhängigkeit vom Speicherinhalt der Registerzelle (9) gekoppelt ist.

2. Schaltungsanordnung nach Anspruch 1,
**dadurch gekennzeichnet, daß**
eine flüchtige Speicherzelle (5) vorgesehen ist, die mit einem Dateneingang (11, 12) der Ansteuerschaltung zur Übermittlung eines Datensignals (A, A') gekoppelt ist zum dauerhaften Verändern des Leitzustands der programmierbaren Verbindung (1) in Abhängigkeit vom Speicherinhalt der flüchtigen Speicherzelle (5).

3. Schaltungsanordnung nach Anspruch 2,
**dadurch gekennzeichnet, daß**
die programmierbare Verbindung (1) als Antifuse ausgebildet ist, die bei Beaufschlagung mit dem Energieimpuls von einem nichtleitenden in einen leitenden Zustand dauerhaft wechselt.

4. Schaltungsanordnung nach Anspruch 2 oder 3,
**dadurch gekennzeichnet, daß**
die Ansteuerschaltung (2) einen Brenntransistor (6) umfaßt, dessen Steuereingang mit Aktivier- und Dateneingang (11, 12, 13, 14) gekoppelt ist und der in Abhängigkeit von an Steuerund Dateneingang (11, 12, 13, 14) anliegenden Signalen (A, A', B, B') einen Anschluß seiner gesteuerten Strecke, an dem eine Brennspannung (C) zuführbar ist, niederohmig mit einem weiteren Anschluß seiner gesteuerten Strecke verbindet, der mit der programmierbaren Verbindung (1) gekoppelt ist.

5. Schaltungsanordnung nach Anspruch 4,
**dadurch gekennzeichnet, daß**
eingangsseitig am Brenntransistor (6) eine Schaltung zur Pegelerhöhung (P1, P2, N5, N6) vorgesehen ist.

6. Schaltungsanordnung nach einem Ansprüche 1 bis 5,
**dadurch gekennzeichnet, daß**
die Ansteuerschaltung (2) eine UND-Logikschaltung (7) aufweist, welche Aktivier- und Dateneingang (11, 12; 13, 14) in einer UND-Logik miteinander verknüpft und ausgangsseitig mit der programmierbaren Verbindung (1) zu deren Ansteuerung gekoppelt ist.

7. Schaltungsanordnung nach einem der Ansprüche 1 bis 6,
**dadurch gekennzeichnet, daß**
das Schieberegister (3) einen ersten, mit einem ersten Taktsignal (CL1, CL1') steuerbaren Schalter (8) umfaßt, der einen Eingang (17) des Schieberegisters (3) mit einem Eingang der Registerzelle (9) koppelt, und einen zweiten mit einem zweiten Taktsignal (CL2, CL2') steuerbaren Schalter (10) umfaßt, der einen Ausgang der Registerzelle (9) mit einem Ausgang des Schieberegisters (18) koppelt.

8. Schaltungsanordnung nach einem der Ansprüche 1 bis 7,
**dadurch gekennzeichnet, daß**
die Schaltungsanordnung in CMOS-Schaltungstechnik aufgebaut ist.

9. Verwendung zumindest einer Schaltungsanordnung nach einem der Ansprüche 1 bis 8,
in einem Speicherchip.

## Claims

1. Circuit arrangement for driving a programmable link (1), having
- the programmable link (1), which can be programmed with regard to its state of conduction by means of an energy pulse,
- a drive circuit (2) for providing the energy pulse at its output, which is coupled to the programmable link (1), in a manner dependent on signals (A, A', B, B') present on the input side,
- **characterized by** a shift register (3) with at least one register cell (9) for storing an activation signal (B, B'), which is coupled to an activation input (13, 14) of the drive circuit for activating the latter in a manner dependent on the memory content of the register cell (9).

2. Circuit arrangement according to Claim 1,
**characterized in that**
a volatile memory cell (5) is provided, which is coupled to a data input (11, 12) of the drive circuit for the communication of a data signal (A, A') for permanently altering the state of conduction of the programmable link (1) in a manner dependent on the memory content of the volatile memory cell (5).

3. Circuit arrangement according to Claim 2,
**characterized in that**
the programmable link (1) is designed as an antifuse which, upon application of the energy pulse, permanently changes from a nonconducting to a conducting state.

4. Circuit arrangement according to Claim 2 or 3,
**characterized in that**
the drive circuit (2) comprises a blowing transistor (6), whose control input is coupled to activation and data input (11, 12, 13, 14) and which, in a manner dependent on signals (A, A', B, B') present at control and data input (11, 12, 13, 14), connects one terminal of its controlled path, at which a blowing voltage (C) can be fed in, with low impedance to a further terminal of its controlled path, which is coupled to the programmable link (1).

5. Circuit arrangement according to Claim 4,
**characterized in that**
a circuit for level boosting (P1, P2, N5, N6) is provided on the input side of the blowing transistor (6).

6. The circuit arrangement according to one of Claims 1 to 5,
**characterized in that**
the drive circuit (2) has an AND logic circuit (7), which combines activation and data input (11, 12; 13, 14) with one another in an AND logic and, on the output side, is coupled to the programmable link (1) for driving the latter.

7. The circuit arrangement according to one of Claims 1 to 6,
**characterized in that**
the shift register (3) comprises a first switch (8), which can be controlled by a first clock signal (CL1, CL1') and couples an input (17) of the shift register (3) to an input of the register cell (9), and comprises a second switch (10), which can be controlled by a second clock signal (CL2, CL2') and couples an output of the register cell (9) to an output of the shift register (18).

8. The circuit arrangement according to one of Claims 1 to 7,
**characterized in that**
the circuit arrangement is constructed using CMOS circuit technology.

9. Use of at least one circuit arrangement according to one of Claims 1 to 8,
in a memory chip.

## Revendications

1. Montage pour commander une liaison (1) pouvant être programmée, comportant
- la liaison (1) pouvant être programmée par une impulsion d'énergie concernant son état conducteur,
- un circuit (2) de commande pour la mise à disposition en fonction de signaux (A, A', B, B') se trouvant du côté de l'entrée de l'impulsion d'énergie à sa sortie, qui est couplé à la liaison (1) pouvant être programmée,
**caractérisé par** un registre (3) à décalage comportant au moins une cellule (9) de registre pour enregistrer un signal (B, B') d'activation, qui est couplé à une entrée (13, 14) d'activation du circuit de commande pour l'activation de ce dernier en fonction du contenu de mémoire de la cellule (9) de registre.

2. Montage suivant la revendication 1, **caractérisé en ce qu'**il est prévu une cellule (5) de mémoire volatile, qui est couplée à une entrée (11, 12) de données du circuit de commande pour la transmission d'un signal (A, A') de données, pour la modification au cours du temps de l'état de conduction de la liaison (1) pouvant être programmée en fonction du contenu de mémoire de la cellule (5) de mémoire volatile.

3. Montage suivant la revendication 2, **caractérisé en ce que** la liaison (1) pouvant être programmée est validée sous la forme d'un anti-fuse (anti-fusible), qui, lors de l'alimentation en l'impulsion d'énergie, passe de manière permanente d'un état non conducteur à un état conducteur.

4. Montage suivant la revendication 2 ou 3, **caractérisé en ce que** le circuit (2) de commande comporte un transistor (6) d'amorçage, dont l'entrée de commande est couplée à une entrée (11, 12, 13, 14) de données d'activation et qui, en fonction de signaux (A, A', B, B') se trouvant à l'entrée (11, 12, 13, 14) de commande et de données, relie une borne de sa section commandée, à laquelle peut être amenée une tension (C) d'amorçage, à basse impédance, avec une autre borne de sa section commandée, qui est couplée à la liaison (1) pouvant être programmée.

5. Montage suivant la revendication 4, **caractérisé en ce que** du côté de l'entrée du transistor (6) d'amorçage il est prévu un circuit d'élévation de niveau (P1, P2, N5, N6).

6. Montage suivant l'une des revendications 1 à 5, **caractérisé en ce que** le circuit (2) de commande comporte un circuit (7) logique ET qui combine des entrées (11, 12, 13, 14) de données et d'activation dans une logique ET du côté de la sortie et est couplé à la liaison (1) pouvant être programmée en vue de sa commande.

7. Montage suivant l'une des revendications 1 à 6, **caractérisé en ce que** le registre (3) à décalage comporte un premier interrupteur (8) pouvant être commandé par un premier signal (CL1, CL1') d'horloge, interrupteur qui couple une entrée (17) du registre (3) à décalage à une entrée de la cellule (9) de registre, et un deuxième interrupteur (10) pouvant être commandé par un deuxième signal (CL2, CL2') d'horloge, interrupteur qui couple une sortie de la cellule (9) de registre à une sortie du registre (18) à décalage.

8. Montage suivant l'une des revendications 1 à 7, **caractérisé en ce que** le montage est mis en oeuvre dans une technique de circuit CMOS.

9. Utilisation d'au moins un montage suivant l'une des revendications 1 à 8, dans une puce de mémoire.
